**Europäisches Patentamt**

**European Patent Office**

**Office européen des brevets**

(11) Veröffentlichungsnummer: **0 311 804**
**A1**

## (12) EUROPÄISCHE PATENTANMELDUNG

(21) Anmeldenummer: **88115021.3**

(22) Anmeldetag: **14.09.88**

(51) Int. Cl.⁴: **H01L 39/24 , C25D 13/02**

(30) Priorität: **17.09.87 DE 3731275**

(43) Veröffentlichungstag der Anmeldung:
**19.04.89 Patentblatt 89/16**

(84) Benannte Vertragsstaaten:
**AT CH DE FR GB IT LI LU NL SE**

(71) Anmelder: **INTERATOM Gesellschaft mit beschränkter Haftung**
**Friedrich-Ebert-Strasse**
**D-5060 Bergisch-Gladbach 1(DE)**

(72) Erfinder: **Piel, Helmut, Prof.**
**Wettiner Strasse 6 h**
**D-2600 Wuppertal 2(DE)**
Erfinder: **Ponto, Ludwik, Dr.**
**U.L. Kulczynskiego 4, M22**
**PL-02777 Warschau(PL)**

(74) Vertreter: **Mehl, Ernst, Dipl.-Ing. et al**
**Postfach 22 13 17**
**D-8000 München 22(DE)**

(54) **Verfahren zur Herstellung supraleitender keramischer Schichten.**

(57) Zur Herstellung dünner und fest haftender supraleitender Schichten aus einem keramischen Material auf elektrisch leitenden Oberflächen wird ein elektrophoretisches Verfahren sowie ein geeignetes Verfahren zur Vorbereitung des aufzutragenden Materials vorgeschlagen. Als supraleitendes keramisches Material werden betrachtet die Verbindung $Y_1 Ba_2 Cu_3 O_7$ und ähnliche Verbindungen, bei denen das Yttrium durch andere seltene Erden substituiert ist.

FIG 5

# Verfahren zur Herstellung supraleitender keramischer Schichten

Die vorliegende Erfindung betrifft ein Verfahren zur Herstellung dünner und fest haftender supraleitender Schichten aus einem keramischen Material auf elektrisch leitenden Oberflächen.

Als supraleitendes keramisches Material im Sinne der vorliegenden Erfindung sind geeignet die Verbindung $Y\,Ba_2\,Cu_3\,O_{7-x}$ und ähnliche Metall-Verbindungen, bei denen Y (Yttrium) durch andere seltene Erden (wie Eu, Er, Gd etc.) substituiert ist. Von Verbindungen dieser Art ist bekannt, daß sie bei geeigneten Temperaturen supraleitend werden. Materialien dieser Art lassen sich durch Aufdampfen oder Aufsputtern nur als sehr dünne Filme (einige nm) auftragen. Dabei sind die supraleitenden Eigenschaften stark abhängig von der Auswahl des Substrates, d. h. des Trägermaterials.

In der DE-OS 21 10 520.4 wird ein Verfahren zum Herstellen von einen Überzug aufweisenden zementierten Karbidgegenständen beschrieben, bei dem ein feines Pulver aus Titan-Karbid elektrophoretisch in organischer Flüssigkeit mit einer Gleichstromspannung von 10 - 100 Volt aufgetragen und anschließend in reduzierender bzw. inerter Atmosphäre gesintert wird. Für die Herstellung der oben genannten supraleitenden Schichten ist dies Verfahren nicht geeignet.

In der japanischen Patentanmeldung 61-150222 Appl. No 59-272 604 wird vorgeschlagen, glasartige Stoffe feingemahlen kataphoretisch oder durch Zentrifugal-Sedimentation in einer organischen Flüssigkeit aufzutragen, wobei die verschiedenen Bestandteile gemischt und bei hohen Temperaturen in einer oxidierenden Atmosphäre aufgeschmolzen werden. Dieses Aufschmelzen ist für die oben genannten Schichten nicht geeignet.

In der US-PS 34 66 237 wird vorgeschlagen, supraleitende Überzüge aus Zinn auf Niob elektrophoretisch in organischer Flüssigkeit aufzutragen, wobei diese Schicht anschließend in einer nicht oxidierenden Atmosphäre erhitzt wird.

Aufgabe der vorliegenden Erfindung ist ein Verfahren zur Herstellung dünner und fest haftender supraleitender Schichten aus einem keramischen Material auf elektrisch leitenden Oberflächen sowie ein Verfahren zur Vorbereitung des aufzutragenden Materials.

Zur Lösung dieser Aufgabe werden Verfahren nach dem 1. bzw. 2. und 3. Anspruch vorgeschlagen. Die Grundlagen, die Präparation des Ausgangsmaterials und das experimentelle Vorgehen werden im folgenden beschrieben, wobei auf das Literaturverzeichnis durch Zahlen in Klammern hingewiesen wird.

## Grundlagen

### 1.1 Einleitung

Die unter dem Einfluß eines elektrischen Feldes erzielte Abscheidung mikroskopisch feiner bis kolloidaler Teilchen auf einer Elektrode fällt in das Gebiet der Elektrophorese. Die Untersuchungen elektrokinetischer Erscheinungen führen zu dem Schluß, daß an Grenzen verschiedener Phasen (z. B. zwischen Festkörper und Flüssigkeit) elektrische Ladungen auftreten, die unter dem Einfluß eines elektrischen Feldes einen Strom verursachen; dabei trägt eine der beiden Phasen positive, die andere Phase negative Ladung. Tragen z. B. in einer Flüssigkeit suspendierte Festkörperteilchen positive Ladung, wandern sie im elektrischen Feld zur Katode; diesen Prozeß nennt man dementsprechend Kataphorese. Im Falle negativer Teilchenladung spricht man analog von Anaphorese. Erste Veröffentlichungen über die elektrophoretische Bewegung kolloidaler Teilchen unter dem Einfluß elektrischer Felder führen bis ins Jahr 1809 (1) zurück. Die Geschwindigkeit der elektrisch geladenen wandernden Teilchen hängt von der elektrischen Feldstärke in der Flüssigkeit als Wanderungsmedium sowie von der Eigenladung der Teilchen und dem Reibungswiderstand ab (2-6); letzterer wird durch die Größe der wandernden Teilchen, durch ihre Form sowie durch die innere Reibung der Flüssigkeit bestimmt:

$$v = \frac{q \cdot E}{6 \cdot (pi) \cdot r \cdot (nue)} \qquad (1)$$

Dabei bedeuten

v = Wanderungsgeschwindigkeit
q = Teilchenladung
E = elektrische Feldstärke
(pi) = 3,14159...
r = Teilchenradius
(nue) = Viskosität der Flüssigkeit

Eine erste Erklärung für die elektrophoretischen Erscheinungen lieferte Helmholtz (7) mit der Theorie der elektrischen Doppelschicht, nach der an der Phasengrenzfläche fest - flüssig ein elektrokinetisches Spannungsgefälle zwischen den dispergierten Teilchen und der Flüssigkeit (Dispergiermittel) existiert. Die Aufrechterhaltung dieser Spannung kann nach dem Kondensatorprinzip erklärt werden: den Ladungen auf der benetzten Teilchenoberfläche stehen die kompensierenden Gegenionen innerhalb der Flüssigkeit gegenüber. In diesem Zusammenhang kann der geladenen Teilchenoberfläche ein nach Freundlich (8) als (Zeta)-Potential bezeichnetes Potential zugeordnet werden, das die Stabilität einer Suspension sowie die Wechselwirkung von Teilchen untereinander charakterisiert: Eine Suspension ist stabil, wenn das (Zeta)-Potential groß genug ist, um eine gegenseitige bleibende Annäherung der suspendierten Festkörperteilchen zu verhindern.


1.2 Die elektrische Doppelschicht

Die Theorie der elektrischen Doppelschicht wurde von Helmholtz (7) zunächst für die Phasengrenze zwischen Metall und Elektrolyt entwickelt und von Gouy (9), Chapman (10) und Stern (11) modifiziert; sie ist jedoch sinngemäß auch auf die Phasengrenze zwischen kolloiden Teilchen und einer Flüssigkeit anwendbar. Notwendige Voraussetzung für die Ausbildung einer elektrischen Doppelschicht sind geladene Oberflächen. Der Ursprung von Ladungen kann auf funktionelle polare Gruppen, Moleküldissoziation, Ionenadsorption durch Herauslösen von Ionen aus der Flüssigkeit oder Reibungselektrizität zurückgeführt werden. Bei Ionengittern und kovalent gebundenen Kristallverbänden sind die in der Oberfläche liegenden Ionen oder Atome koordinativ ungesättigt. Strukturfremde Atome, Atomgruppen oder Ionen können daher relativ fest gebunden werden und zu einer Aufladung führen. Bei kolloiden Systemen in Dispersionsmitteln hoher Dielektrizitätskonstante (z. B. Wasser) kann ein Aufladungseffekt durch Ionisation von Atomgruppen verursacht werden, die in der Flüssigkeit dissoziiert werden.

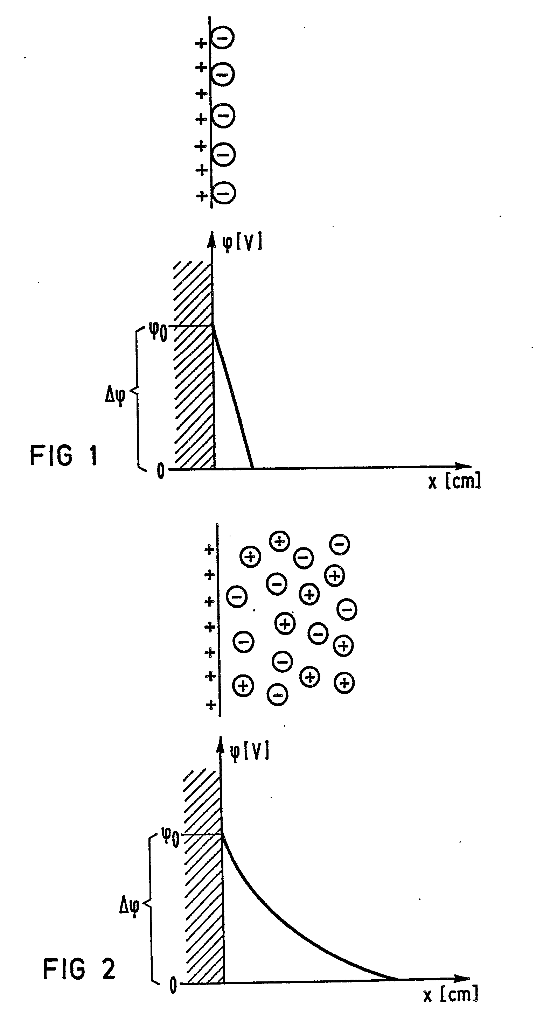

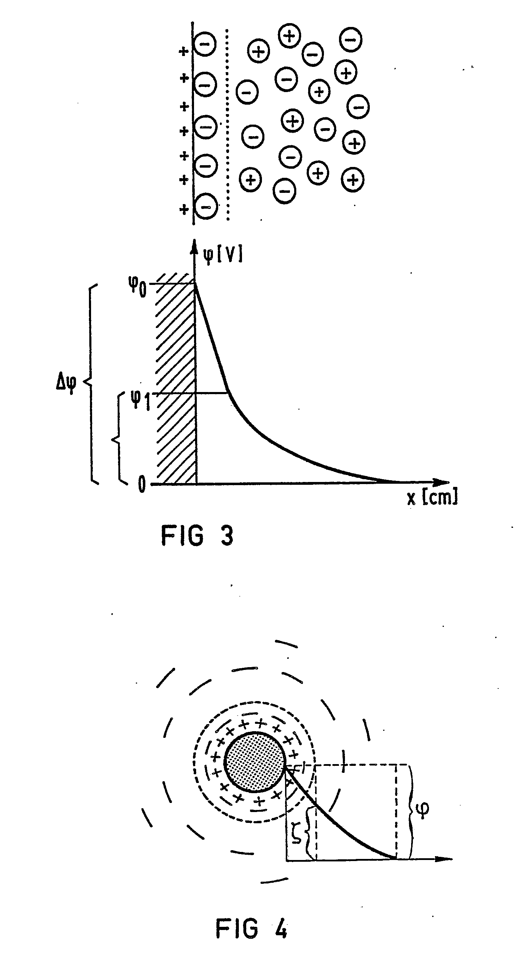

Die Fig. 1 bis 4 zeigen schematisch die aus den oben angeführten theoretischen Ansätzen folgenden unterschiedlichen Potentialverteilungen innerhalb der Doppelschicht. Nach Helmholtz (Fig. 1) ist das betrachtete Teilchen an der Grenzfläche zwischen Teilchen und Flüssigkeit von einer Schicht adsorbierter Ionen umgeben, die von einer Schicht Ionen entgegengesetzter Ladungen umhüllt ist. Gegenüber der an die Teilchenoberfläche gebundenen flächenförmigen Ladungsschicht bildet sich auch in der Flüssigkeit eine flächenförmige elektrische Schicht aus; die Entfernung beider entgegengesetzt geladener Schichten entspricht molekularen Dimensionen. Gouy und Chapman erweitern diese Vorstellung ausgehend von der Annahme, daß sich die Doppelschicht tiefer in die Flüssigkeit erstreckt (diffuse Doppelschicht, Fig. 2). Die diffuse Doppelschicht an der Grenzfläche zwischen Teilchen und Flüssigkeit entsteht durch die Wirkung zweier entgegengerichteter Einflüsse: Die Bildung einer starren Doppelschicht im Helmholtz'schen Sinne wird durch elektrische Anziehung angestrebt, während die molekulare Wärmebewegung zu einer Flüssigkeitsvolumen führt. Demnach ist die in der Flüssigkeit befindliche Doppelschichtkomponente nicht flächenförmig starr, sondern diffus ausgebildet. Die Dicke der Doppelschicht kann in die Größenordnung einiger nm gelangen. Die Theorie nach Stern führt zu einer Komposition beider bisher beschriebener Vorstellungen: Die Doppelschicht zerlegt sich danach in eine praktisch fest an der Teilchenoberfläche haftende Schicht (Dicke einige 0.1 nm) und in eine diese umgebende diffuse bewegliche Schicht. In der kompakten Sternschicht fällt das Potential zunächst steil linear, im diffusen Gebiet geht dieser Verlauf in einen exponentiellen Abfall über. Das anfangs erwähnte (Zeta)-Potential wird dabei definiert über die Differenz der Potentiale an der äußeren Grenze der kompakten Sternschicht und im Inneren der Flüssigkeit (Fig. 3). Fig. 4 zeigt ein positiv geladenes Teilchen mit (Zeta)-Potential suspendiert in der Flüssigkeit. Unter dem Einfluß eines elektrischen Feldes bewegt sich das Teilchen samt der ihm fest anhaftenden kompakten Sternschicht und führt zu einer tangentialen Verschiebung von starrer und diffuser Schicht gegeneinander. Einfache Modellrechnungen nach Smoluchowski (12) bzw. Debye-Hückel (13) verknüpfen das (Zeta)-Potential mit der Wanderungsgeschwindigkeit v der Teilchen, der Viskosität (nue) und der Dieelektrizitätskonstanten (epsilon) der elektrischen Doppelschicht sowie dem angelegten elektrischen Feld E:

$$(Zeta) = \frac{K \cdot (pi) \cdot (nue) \cdot v}{(epsilon) \cdot E} \qquad (2)$$

Der Faktor K beträgt 4 für zylindrische Teilchengeometrie (12) und 6 für kugelförmige Teilchen (13). Typische Werte für das (Zeta)-Potential liegen zwischen 0.02 und 0.1 Volt. Die Definition des (Zeta)-Potentials gilt ursprünglich nur für ionisierte Flüssigkeiten. Inwieweit die elektrophoretischen Erscheinungen kolloidaler Teilchen in organischen Flüssigkeit ebenfalls durch das (Zeta)-Potential bestimmt werden, ist nicht endgültig geklärt (vgl. ausführliche Darstellung in (14)).

## 2 Präparation des Ausgangsmaterials

Das zur Herstellung einer feinen Suspension verwendete Ausgangsmaterial besteht aus den üblichen pulverförmigen hochreinen (99.999 %ig) Komponenten $Y_2O_3$, $BaCO_3$ und $CuO$. Wie die experimentellen Untersuchungen gezeigt haben, ist es für die erfolgreiche Anwendung des elektrophoretischen Verfahrens notwendig, das Pulver möglichst fein zu mahlen, da zu große Teilchen wegen ihrer relativ großen Masse nicht in der Flüssigkeit suspendieren. Zunächst hat es sich als erforderlich erwiesen, vor dem Mahlen die einzelnen pulverförmigen Bestandteile mehrere Stunden bei einer Temperatur oberhalb von 100 °C zu trocknen, um eine Klumpung durch Aufnahme von Wasser zu vermeiden. Die getrockneten Ausgangspulver wurden jeweils eine Stunde mit Hilfe einer Planeten-Kugel-Mühle gemahlen, anschließend in dem erforderlichen stöchiometrischen Verhältnis (15.12 %gew $Y_2O_3$, 52.85 %gew $BaCO_3$, 32.03 %gew $CuO$) gemischt und erneut gemahlen. Dabei haben sich zwei Verfahren alternativ als erfolgreich herausgestellt:

1. Eine Stunde Mahlen in getrocknetem Zustand.

2. 30 Min. Mahlen in getrocknetem Zustand, anschließend 30 Min.

Mahlen unter Zugabe von 1-Butanol (etwa 50 % Gewicht) und danach mehrere Stunden getrocknet (Temperatur über 120 °C). Im Anschluß an den Mahlvorgang wurde das Pulver bei einer Temperatur von 925 °C für 40 h an Luft bzw. unter $O_2$-Atmosphäre ausgeheizt. Das bereits teilweise gesinterte Material wurde weitere 30 Min. trocken, anschließend 30 Min. in 1-Butanol gemahlen. Nach Abschluß des vollständigen Mahlvorganges wurde das Pulver durch Zugabe von 10 ml 1-Butanol pro 1 g Pulver in eine Suspension überführt.

## 3 Experimentelles Vorgehen

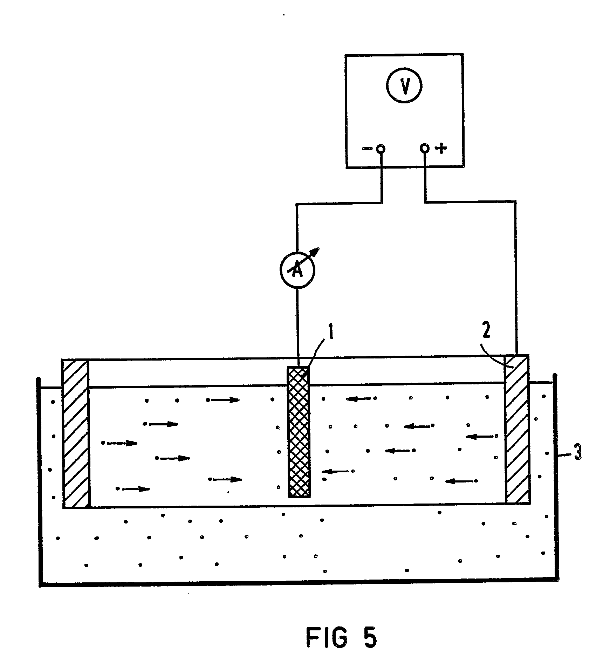

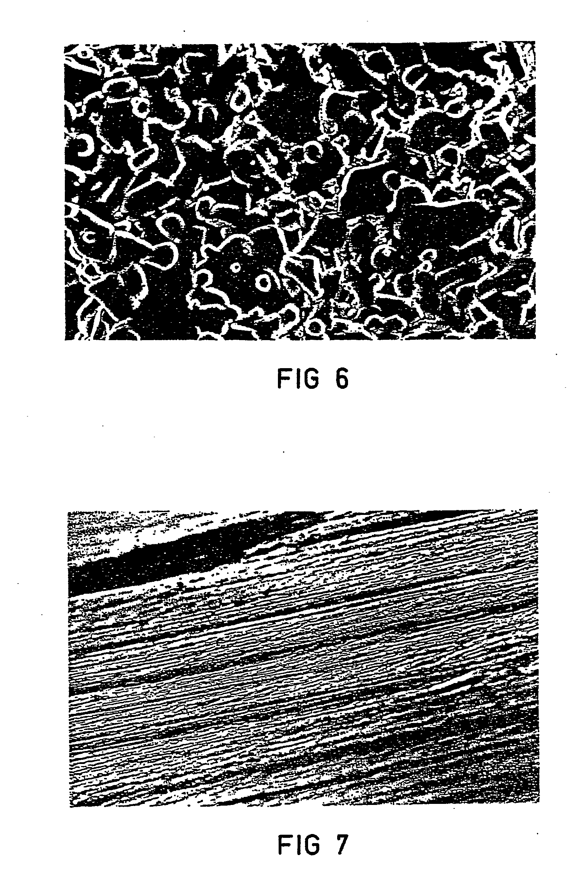

Ein doppelwandiges, thermisch regel- und stabilisierbares Glasgefäß diente zur Aufnahme der Suspension. Es hat sich gezeigt, daß eine Suspensionstemperatur von mehr als 40 °C zu positiven Ergebnissen führt. Der prinzipielle experimentelle Aufbau sowie die elektrische Verschaltung des Versuchs zur kataphoretischen Abscheidung von gehen aus Fig. 5 hervor. Das zur Abscheidung des keramischen Pulvers verwendete Metallsubstrat (Silber- oder Palladiumfolie) wird als Katode 1 geschaltet. Als Anode 2 dient ein an einem Messingstab befestigtes rundgebogenes Kupferband; neben Kupfer eignen sich auch andere Metalle wie z. B. Edelstahl und Aluminium als Anodenmaterial. Die Kathode 1 wurde so in die Suspension getaucht, daß sie von dem ebenfalls eingetauchten ringförmigen Anode 2 in dem Gefäß 3 umgeben wurde. Die Zellenspannung sollte mehr als 20 V betragen, Werte bis 120 V wurden erfolgreich getestet. Die Stromdichte sowie die Abscheidungsrate hängen von der Pulverkonzentration in der Suspension ab. Typische Werte für ungebrauchte Suspensionen liegen bei $10^{-2}$ mA/cm$^2$ bzw. 10 µm/min. Auf das jeweilige Substrat wurde zunächst eine bis zu 10 µm dicke Schicht aufgetragen; anschließend wurde es bei ca. 160 °C für 30 Min. getrocknet und 5 Min. bei 925 °C unter Luft gesintert. Dieses Verfahren wurde viermal wiederholt. Die fertig abgeschiedene Schicht wurde abschließend für 20 h unter $O_2$-Atmosphäre bei 925 °C gesintert und anschließend mit Hilfe elektronenmikroskopischer Aufnahmen analysiert. Fig. 6 zeigt eine aufgetragene Oberfläche auf Ag-Substrat bei 1000facher Vergrößerung und seitlicher Betrachtung. Fig. 7 zeigt die Oberfläche bei vertikaler Betrachtung. Als geeignete Träger haben sich bewährt Metalle wie beispielsweise Silber oder Palladium, auch wenn diese in dünner Schicht auf anderen Metallen oder auf keramischen Werkstücken aufgetragen sind. Als Suspensionsflüssigkeit kann auch 4-Hexan mit 1-Butanol gemischt oder Oktanol verwendet werden. In einem weiteren Versuch wurden 20 g/l Y Ba$_2$ Cu$_3$ O$_7$ in 2-Propanol (Isopropylalkohol) suspendiert und bei einer Temperatur von 60 °C einer Spannung von 50 V/cm und zwar zweimal jeweils für 30 sek. ausgesetzt. Dabei betrug die Abscheidungsrate 1 μm/sek.

Die hier vorgeschlagenen Verfahren sind von besonderer Bedeutung für die Herstellung supraleitender Schichten auf komplex gestalteten Oberflächen, wo Laser- oder Sputter-Verfahren nicht geeignet sind, beispielsweise innerhalb von Rohren oder Hohlkörpern wie Hochfrequenz-Resonatoren oder Wellenleitern für Hochfrequenz, die rotationssymmetrisch sein oder auch einen eckigen Querschnitt haben können.

Für stabförmig/längliche Gegenstände als Katode hat es sich als zweckmäßig erwiesen, wie oben bereits beschrieben, diese von einer ringförmigen Anode aus zu beschichten. Andererseits werden Rohre oder andere Hohlkörper von innen zweckmäßigerweise mit einer in ihrer Mitte angeordneten stabförmigen Anode beschichtet.


Literaturverzeichnis

(1) Reuss, "Memoires de la Societe imperiale de Naturalistes de Moscou" Band 2, Seite 327, (1809)

(2) H. Aebi, "Einführung in die praktische Biochemie", Akademische Verlagsgesellschaft Ffm. (1965)

(3) R. Backausz, "Immundiffusion und Immunelektrophorese" VEB Gustav Fischer Verlag, Jena (1967)

(4) H. Friemd, "Immunologische Arbeitsmethoden" VEB Gustav Fischer Verlag, Jena (1976)

(5) K. Lauber, "Chemie im Laboratorium", 3. Auflage S. Karger, Basel (1975)

(6) G. Ohlenschläger, I. Berger, "Grundlagen der Elektrophorese und ihre Anwendungstechniken", GIT Labormedizin (1978)

(7) H. v. Helmholtz, Ann. d. Phys. Band 7, Seite 337, (1879)

(8) H. Freundlich, "Colloid and Capillary Chemistry", (übersetzt von H. J. Hatfield), London (Methuen) Seite 242 (1922)

(9) G. m. J. Gouy, J. Phys. Chem. 4, 9, (1910) Ann. Physik Band 7, Seite 129 (1917)

(10) D. L. Chapman, Phil. Mag. (6), 25, Seite 475, (1913)

(11) O. Stern, Zeitschrift Elektrochemie Band 30, Seite 508 (1924)

(12) M. V. Smoluchowski, Graetz Handbuch d. Elektrizität u. d. Magnetismus, Band II, Seite 385, Leipzig (1921)

(13) P. Debye, E. Hückel, Physik Zeitschrift, 25, 49 (1924)

(14) J. Veigl, "Elektrokinetische Grenzflächenvorgänge" Verlag Chemie Weinheim - New York (1977)

## Ansprüche

1. Verfahren zur Herstellung dünner und fest haftender supraleitender Schichten aus einem keramischen Material auf elektrisch leitenden Oberflächen,
**dadurch gekennzeichnet,** daß das Material in feingemahlener Form in einer nicht wässerigen Suspension kataphoretisch aufgetragen, getrocknet und in oxidierender Atmosphäre gesintert wird.

2. Verfahren zur Vorbereitung des aufzutragenden Materials nach Anspruch 1, **dadurch gekennzeichnet,** daß die vorgesehenen Metalle in Oxid-Form getrocknet, fein gemahlen, im stöchiometrischen Verhältnis gemischt, gemeinsam in einer organischen Flüssigkeit gemahlen, anschließend getrocknet und bei hohen Temperaturen in sauerstoffhaltiger Atmosphäre gesintert, nach dem Sintern in einer organischen Flüssigkeit gemahlen und durch Sedimentation klassiert werden.

3. Verfahren nach Anspruch 1, **dadurch gekennzeichnet,** daß dieses Verfahren auf der gleichen Oberfläche mehrfach wiederholt wird.

87 P 8570 E

FIG 1

φ[V]

φ0

Δφ

0

x [cm]

FIG 2

φ[V]

φ0

Δφ

0

x [cm]

**FIG 3**

**FIG 4**

FIG 5

87 P 8570 E

FIG 6

FIG 7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | US-A-3 466 237 (A.C. BARBER)<br>--- | | H 01 L 39/24<br>C 25 D 13/02 |
| D,A | PATENT ABSTRACTS OF JAPAN, Band 10, Nr. 347 (E-457)[2403], 21. November 1986, Seite 119 E 457; & JP-A-61 150 222 (SHINDENGEN ELECTRIC MFG CO. LTD) 08-07-1986<br>--- | | |
| D,A | DE-A-2 110 520 (H. AKIO)<br>----- | | |

RECHERCHIERTE
SACHGEBIETE (Int. Cl.4)

H 01 L    39
C 25 D    13

Der vorliegende Recherchenbericht wurde für alle Patentansprüche erstellt

| Recherchenort | Abschlußdatum der Recherche | Prüfer |
|---|---|---|
| DEN HAAG | 12-12-1988 | PELSERS L. |

EPO FORM 1503 03.82 (P0403)